# EUROPEAN PATENT SPECIFICATION

(11) **EP 2 278 620 B1**
(45) Date of publication and mention of the grant of the patent: **22.05.2013**
(21) Application number: 08014807.5
(22) Date of filing: 21.08.2008
(51) Int. Cl.: H01L 27/24, H01L 27/22, G11C 11/16, G11C 13/00, H01L 29/732, H01L 29/10

(54) **Integrated circuit, memory cell, memory module, and method of manufacturing an integrated circuit**
Integrierte Schaltung, Speicherzelle, Speichermodul und Verfahren zur Herstellung einer integrierten Schaltung
Circuit intégré, cellule de mémoire, module de mémoire, et procédé de fabrication d'un circuit intégré

(43) Date of publication of application: 26.01.2011
(73) Proprietor: Qimonda AG, 81739 München (DE)
(72) Inventor: Risch, Lothar, 85579 Neubiberg (DE); Bartels, Martin, 01099 Dresden (DE); Happ, Thomas, 01109 Dresden (DE)
(74) Representative: Epping - Hermann - Fischer

(56) References cited:
- DE-A1-102006 040 238
- US-A1- 2008 185 571

## Description

### Briefing Description of Drawings

Integrated circuits having resistance changing memory elements are known. It is desirable to increase the memory depth of such integrated circuits while at the same time avoiding a deterioration of the characteristics/performance of the integrated circuits.

### Background Art

US patent application publication US 2008/0185571 A1 describes a resistance changing memory in which the resistance changing memory elements are disposed above the semiconductor substrate. The select devices are bipolar transistors having a base area connected to a word line portion disposed in a trench. The trench is filled with an isolation material.

German patent application DE 102006040238 A1 describes an integrated circuit with resistance changing memory elements connected to memory element select devices that are vertical field effect transistors.

### Summary of the Invention

According to one embodiment of the present invention, an integrated circuit is provided. The integrated circuit comprises: resistance changing memory elements arranged above a semiconductor substrate, memory element select devices each arranged within an active area formed within the semiconductor substrate, the select devices each being a bipolar transistor comprising an emitter area, a base area and a collector area, wherein the base area of each select device is connected to a word line formed within a word line trench reaching through the semiconductor substrate to a top surface of the base area or into the base area, wherein each memory element is connected to one of the select devices and wherein at least a part of the inner walls of the word line trench is covered with an isolation layer, which laterally isolates the word line against the active area, wherein the base area includes a highly doped semiconductor area which is arranged below the word line trench.

According to one embodiment of the present invention, a method of manufacturing an integrated circuit is provided which comprises: forming a plurality of memory element select devices within corresponding active areas formed within a semiconductor substrate, wherein the select devices in each case are a bipolar transistor comprising an emitter area, a base area and a collector area, forming a plurality of word line trenches within the semiconductor substrate, each word line trench reaching from the top surface of the semiconductor substrate to top surfaces of a plurality of base areas or into a plurality of base areas, filling the word line trenches with conductive material, forming, above the semiconductor substrate, resistance changing memory elements being electrically connected to the select devices, covering at least a part of the inner walls of the word line trenches with an isolation layer which in each case laterally isolates the conductive material against the corresponding active area, and, for each memory element, forming a highly doped semiconductor area in the base area below the word line trench.

### Brief Description of the Drawings

In the drawings, like reference characters generally refer to the same parts throughout the different views. The drawings are not necessarily to scale, emphasis instead generally being placed upon illustrating the principles of the invention. In the following description, various embodiments of the invention are described with reference to the following drawings, in which:
Figure 1 shows a magneto-resistive memory element;
Figure 2 shows an integrated circuit useable in conjunction with the magneto-resistive memory element shown in figure 1;
Figure 3 shows a schematic cross-sectional view of a phase change memory element;
Figure 4 shows a schematic drawing of an integrated circuit using resistance changing memory elements;
Figure 5 shows a schematic cross-sectional view of a carbon memory element set to a first switching state;
Figure 6 shows a schematic cross-sectional view of a carbon memory element set to a second switching state;
Figure 7a shows a schematic drawing of a resistance changing memory cell;
Figure 7b shows a schematic drawing of a resistance changing memory cell;
Figure 8 shows a schematic cross-sectional view of an integrated circuit ;
Figure 9 shows a schematic cross-sectional view of an integrated circuit according to one embodiment of the present invention;
Figure 10 shows a flow chart of a method of manufacturing an integrated circuit ;
Figure 11 shows a schematic cross-sectional view of a manufacturing stage of a method of manufacturing an integrated circuit according to one embodiment of the present invention;
Figure 12 shows a schematic cross-sectional view of a manufacturing stage of a method of manufacturing an integrated circuit according to one embodiment of the present invention;
Figure 13 shows a schematic cross-sectional view of a manufacturing stage of a method of manufacturing an integrated circuit according to one embodiment of the present invention;
Figure 14 shows a schematic cross-sectional view of a manufacturing stage of a method of manufacturing an integrated circuit according to one embodiment of the present invention;
Figure 15 shows a schematic cross-sectional view of a manufacturing stage of a method of manufacturing an integrated circuit according to one embodiment of the present invention;
Figure 16 shows a schematic cross-sectional view of a manufacturing stage of a method of manufacturing an integrated circuit according to one embodiment of the present invention;
Figure 17 shows a schematic cross-sectional view of a manufacturing stage of a method of manufacturing an integrated circuit according to one embodiment of the present invention;
Figure 18 shows a schematic top view of an integrated circuit according to one embodiment of the present Invention;
Figure 19 shows a schematic cross-sectional view of the integrated circuit shown in figure 18;
Figure 20 shows a schematic cross-sectional view of an integrated circuit according to one embodiment of the present invention;
Figure 21 shows a schematic top view of the integrated circuit shown in figure 20;
Figure 22 shows a schematic cross-sectional view of the integrated circuit shown in figure 21;
Figure 23A shows a doping profile of a select device of an integrated circuit according to one embodiment of the present invention;
Figure 23B shows a gain factor simulation resulting from the doping profile shown in figure 23A;
Figure 24 shows a doping profile of a select device of an integrated circuit according to one embodiment of the present invention;
Figure 25 shows a gain factor simulation resulting from the doping profile shown in figure 24;
Figure 26a shows a schematic perspective view of a memory module according to one embodiment of the present invention; and
Figure 26b shows a schematic perspective view of a memory module according to one embodiment of the present invention.

### Description

Since resistance changing memory elements of embodiments of the integrated circuit according to the present invention may be magneto-resistive memory elements, a brief discussion of magneto-resistive memory elements will be given. In magneto-resistive memory elements, material magnetization and hence electron spin is used to store information. A collection of magneto-resistive memory elements form a magnetic random-access memory (MRAM) device. Digital information, represented e.g. as a "0" or "1", is stored in the alignment of magnetic moments. The resistance of the memory element depends on the moment's alignment. Digital information is read from a memory element by detecting the resistance of the memory element.

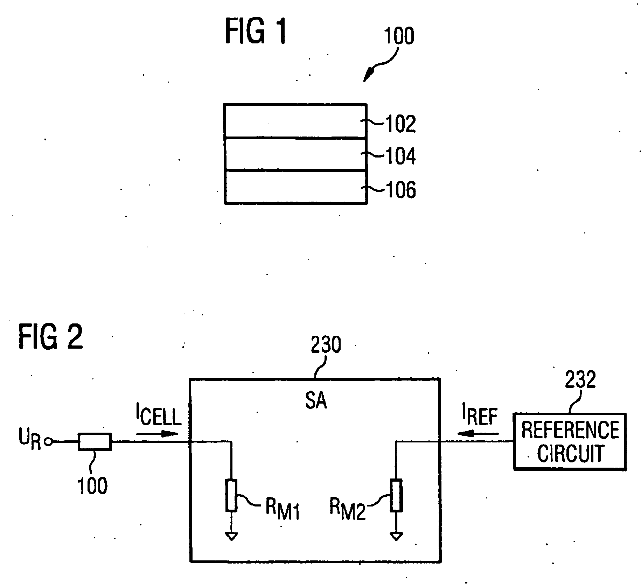

Fig. 1 illustrates a perspective view of a magneto-resistive memory element 100 having a soft layer 102, a tunnel layer 104, and a hard layer 106, for example. Soft layer 102 and hard layer 106 preferably include a plurality of magnetic metal layers, for example, eight to twelve layers of materials such as PtMn, CoFe, Ru, and NiFe, as examples. Digital information is represented by the alignment of the magnetic moment of the soft layer 102 of the magneto-resistive memory element 100.

In order to read the digital information (logic state) stored in a selected memory element 100, a schematic such as the one shown in Fig. 2, including a sense amplifier (SA) 230, may be used. A reference voltage U_{R} is applied to one end of the selected magneto-resistive memory element 100. The other end of the selected magneto-resistive memory element 100 is coupled to a measurement resistor Rₘ₁.The other end of the measurement resistor Rₘ₁ is coupled to ground. The current running through the selected magneto-resistive memory element 100 is equal to current I_{cell}. A reference circuit 232 supplies a reference current I_{ref} that is run into measurement resistor Rₘ₂. The other end of the measurement resistor Rₘ₂ is coupled to ground, as shown.

Since resistance changing memory elements of embodiments of the integrated circuit according to the present invention may be phase change memory elements, a brief discussion of phase change memory elements will be given. Phase change memory elements include a phase change material. The phase change material can be switched between at least two different crystallization states (i.e. the phase change material may adopt at least two different degrees of crystallization), wherein each crystallization state may be used to represent a memory state. When the number of possible crystallization states is two, the crystallization state having a high degree of crystallization is also referred to as "crystalline state", whereas the crystallization state having a low degree of crystallization is also referred to as "amorphous state". Different crystallization states can be distinguished from each other by their differing electrical properties, and in particular by their different resistances. For example, a crystallization state having a high degree of crystallization (ordered atomic structure) generally has a lower resistance than a crystallization state having a low degree of crystallization (disordered atomic structure). For sake of simplicity, it will be assumed in the following that the phase change material can adopt two crystallization states (an "amorphous state" and a "crystalline state"), however it will be understood that additional intermediate states may also be used.

Phase change memory elements may change from the amorphous state to the crystalline state (and vice versa) due to temperature changes of the phase change material. These temperature changes may be caused using different approaches. For example, a current may be driven through the phase change material (or a voltage may be applied across the phase change material). Alternatively, a current or a voltage may be fed to a resistive heater located adjacent to the phase change material. To determine the memory state of a resistance changing memory element, a sensing current may be routed through the phase change material (or a sensing voltage may be applied across the phase change material), thereby sensing its resistance which represents the memory state of the memory element.

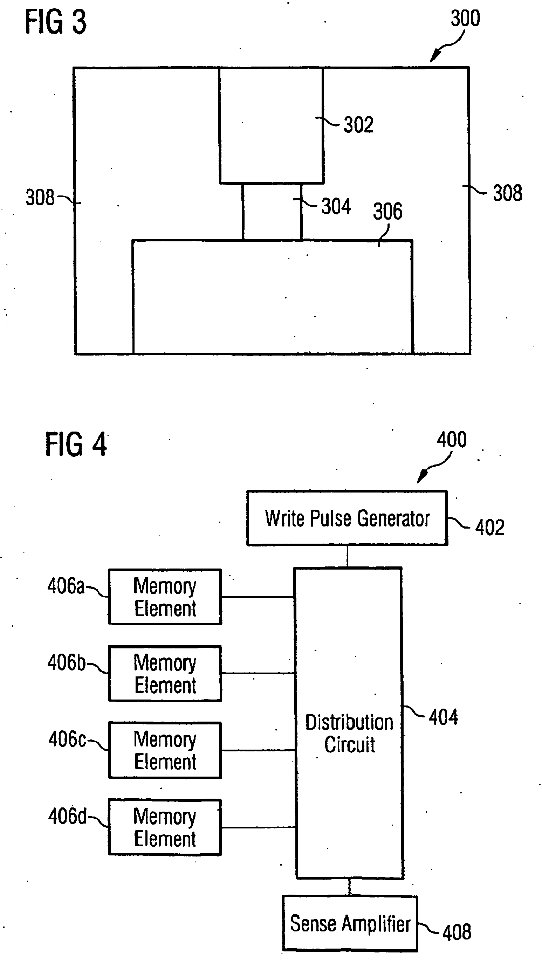

Figure 3 illustrates a cross-sectional view of an exemplary phase change memory element 300 (active-in-via type). The phase change memory element 300 includes a first electrode 302, a phase change material 304, a second electrode 306, and an insulating material 308. The phase change material 304 is laterally enclosed by the insulating material 308. To use the phase change memory element, a selection device (not shown), such as a transistor, a diode, or another active device, may be coupled to the first electrode 302 or to the second electrode 306 to control the application of a current or a voltage to the phase change material 304 via the first electrode 302 and/or the second electrode 306. To set the phase change material 304 to the crystalline state, a current pulse and/or voltage pulse may be applied to the phase change material 304, wherein the pulse parameters are chosen such that the phase change material 304 is heated above its crystallization temperature, generally keeping the temperature below the melting temperature of the phase change material 304. To set the phase change material 304 to the amorphous state, a current pulse and/or voltage pulse may be applied to the phase change material 304, wherein the pulse parameters are chosen such that the phase change material 304 is briefly heated above its melting temperature, and is quickly cooled.

The phase change material 304 may include a variety of materials. According to one embodiment, the phase change material 304 may include or consist of a chalcogenide alloy that includes one or more elements from group VI of the periodic table. According to another embodiment, the phase change material 304 may include or consist of a chalcogenide compound material, such as GeSbTe, SbTe, GeTe or AgInSbTe. According to a further embodiment, the phase change material 302 may include or consist of chalcogen free material, such as GeSb, GaSb, InSb, or GeGaInSb. According to still another embodiment, the phase change material 302 may include or consist of any suitable material including one or more of the elements Ge, Sb, Te, Ga, Bi, Pb, Sn, Si, P, O, As, In, Se, and S.

According to one embodiment, at least one of the first electrode 302 and the second electrode 306 may include or consist of Ti, V, Cr, Zr, Nb, Mo, Hf, Ta, W, or mixtures or alloys thereof. According to another embodiment, at least one of the first electrode 302 and the second electrode 406 may include or consist of Ti, V, Cr, Zr, Nb, Mo, Hf, Ta, W and one or more elements selected from the group consisting of B, C, N, O, Al, Si, P, S, and/or mixtures and alloys thereof. Examples of such materials include TiCN, TiAIN, TiSiN, W-Al₂O₃ and Cr-Al₂O₃.

Figure 4 illustrates a block diagram of a memory device 400 including a write pulse generator 402, a distribution circuit 404, phase change memory elements 406a, 406b, 406c, 406d (for example phase change memory elements 300 as shown in figure 3), and a sense amplifier 408. According to one embodiment, the write pulse generator 402 generates current pulses or voltage pulses that are supplied to the phase change memory elements 406a, 406b, 406c, 406d via the distribution circuit 404, thereby programming the memory states of the phase change memory elements 406a, 406b, 406c, 406d. According to one embodiment, the distribution circuit 404 includes a plurality of transistors that supply direct current pulses or direct voltage pulses to the phase change memory elements 406a, 406b, 406c, 406d or to heaters being disposed adjacent to the phase change memory elements 406a, 406b, 406c, 406d.

As already indicated, the phase change material of the phase change memory elements 406a, 406b, 406c, 406d may be changed from the amorphous state to the crystalline state (or vice versa) under the influence of a temperature change. More generally, the phase change material may be changed from a first degree of crystallization to a second degree of crystallization (or vice versa) under the influence of a temperature change. For example, a bit value "0" may be assigned to the first (low) degree of crystallization, and a bit value "1" may be assigned to the second (high) degree of crystallization. Since different degrees of crystallization imply different electrical resistances, the sense amplifier 404 is capable of determining the memory state of one of the phase change memory elements 406a, 406b, 406c, or 406d in dependence on the resistance of the phase change material.

To achieve high memory densities, the phase change memory elements 406a, 406b, 406c, 406d may be capable of storing multiple bits of data, i.e. the phase change material may be programmed to more than two resistance values. For example, if a phase change memory element 406a, 406b, 406c, 406d is programmed to one of three possible resistance levels, 1.5 bits of data per memory element can be stored. If the phase change memory element is programmed to one of four possible resistance levels, two bits of data per memory element can be stored, and so on.

The embodiment shown in Figure 4 may also be applied in a similar manner to other types of resistance changing memory elements like programmable metallization elements (PMCs), mage nto-resistive memory elements (e.g. MRAMs), organic memory elements (e.g. ORAMs), or transition metal oxide memory elements (TMOs).

Another type of resistance changing memory element may be formed using carbon as a resistance changing material. Generally, amorphous carbon that is rich is sp³-hybridized carbon (i.e., tetrahedrally bonded carbon) has a high resistance, while amorphous carbon that is rich in sp²-hybridized carbon (i.e., trigonally bonded carbon) has a low resistance. This difference in resistance can be used in a resistance changing memory cell.

In one embodiment, a carbon memory element may be formed in a manner similar to that described above with reference to phase change memory elements. A temperature-induced change between an sp³-rich state and an sp²-rich state may be used to change the resistance of an amorphous carbon material. These differing resistivities may be used to represent different memory states. For example, a high resistance sp³-rich state can be used to represent a "0", and a low resistance sp²-rich state can be used to represent a "1". It will be understood that intermediate resistance states may be used to represent multiple bits, as discussed above.

Generally, in this type of carbon memory element, application of a first temperature causes a change of high resistance sp³-rich amorphous carbon to relatively low resistance sp²-rich amorphous carbon. This conversion can be reversed by application of a second temperature, which is typically higher than the first temperature. As discussed above, these temperatures may be provided, for example, by applying a current and/or voltage pulse to the carbon material. Alternatively, the temperatures can be provided by using a resistive heater that is disposed adjacent to the carbon material.

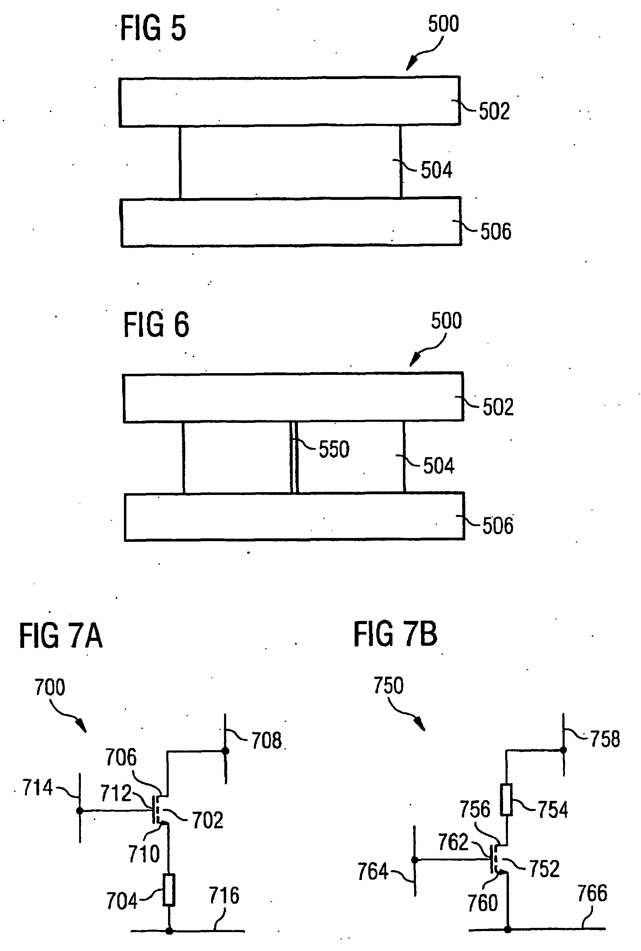

Another way in which resistance changes in amorphous carbon can be used to store information is by field-strength induced growth of a conductive path in an insulating amorphous carbon film. For example, applying voltage or current pulses may cause the formation of a conductive sp² filament in insulating sp³-rich amorphous carbon. The operation of this type of resistive carbon memory is illustrated in Figures 5 and 6.

Figure 5 shows a carbon memory element 500 that includes a top contact 502, a carbon storage layer 504 including an insulating amorphous carbon material rich in sp³-hybridized carbon atoms, and a bottom contact 506. As shown in Figure 6, by forcing a current (or voltage) through the carbon storage layer 504, an sp² filament 550 can be formed in the sp³-rich carbon storage layer 504, changing the resistance of the memory element. Application of a current (or voltage) pulse with higher energy (or, in some embodiments, reversed polarity) may destroy the sp² filament 550, increasing the resistance of the carbon storage layer 504. As discussed above, these changes in the resistance of the carbon storage layer 504 can be used to store information, with, for example, a high resistance state representing a "0" and a low resistance state representing a "1". Additionally, in some embodiments, intermediate degrees of filament formation or formation of multiple filaments in the sp³-rich carbon film may be used to provide multiple varying resistance levels, which may be used to represent multiple bits of information in a carbon memory element. In some embodiments, alternating layers of sp³-rich carbon and sp²-rich carbon may be used to enhance the formation of conductive filaments through the sp³-rich layers, reducing the current and/or voltage that may be used to write a value to this type of carbon memory.

Resistance changing memory elements, such as the phase change memory elements and carbon memory elements described above, may be used as part of a memory cell, along with a transistor, diode, or other active component for selecting the memory cell. Figure 7A shows a schematic representation of such a conventional memory cell that uses a resistance changing memory element. The memory cell 700 includes a select transistor 702 and a resistance changing memory element 704. The select transistor 702 includes a source 706 that is connected to a bit line 708, a drain 710 that is connected to the memory element 704, and a gate 712 that is connected to a word line 714. The resistance changing memory element 704 also is connected to a common line 716, which may be connected to ground, or to other circuitry, such as circuitry (not shown) for determining the resistance of the memory cell 700, for use in reading. Alternatively, in some configurations, circuitry (not shown) for determining the state of the memory cell 700 during reading may be connected to the bit line 708. It should be noted that as used herein the terms connected and coupled are intended to include both direct and indirect connection and coupling, respectively.

To write to the memory cell 700, the word line 714 is used to select the memory cell 700, and a current (or voltage) pulse on the bit line 708 is applied to the resistance changing memory element 704, changing the resistance of the resistance changing memory element 704. Similarly, when reading the memory cell 700, the word line 714 is used to select the cell 700, and the bit line 708 is used to apply a reading voltage (or current) across the resistance changing memory element 704 to measure the resistance of the resistance changing memory element 704.

The memory cell 700 may be referred to as a 1T1J cell, because it uses one transistor, and one memory junction (the resistance changing memory element 704). Typically, a memory device will include an array of many such cells. It will be understood that other configurations for a 1T1J memory cell, or configurations other than a 1T1J configuration may be used with a resistance changing memory element.

For example, in Figure 7B, an alternative arrangement for a 1T1J memory cell 750 is shown, in which a select transistor 752 and a resistance changing memory element 754 have been repositioned with respect to the configuration shown in Figure 7A. In this alternative configuration, the resistance changing memory element 754 is connected to a bit line 758, and to a source 756 of the select transistor 752. A drain 760 of the select transistor 752 is connected to a common line 766, which may be connected to ground, or to other circuitry (not shown), as discussed above. A gate 762 of the select transistor 752 is controlled by a word line 764.

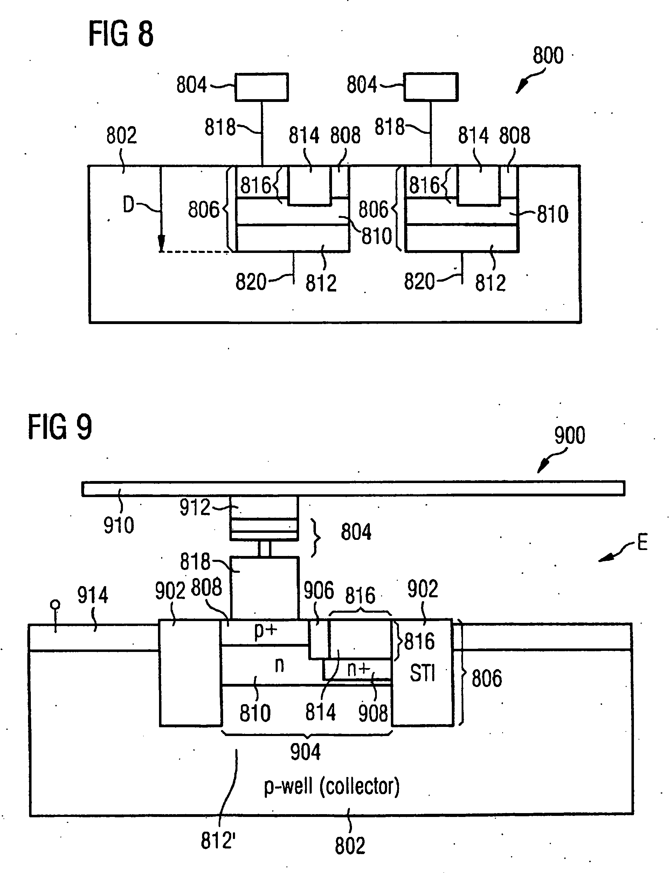

Figure 8 shows an integrated circuit 800 The integrated circuit 800 includes a semiconductor substrate 802, resistance changing memory elements 804 arranged above the semiconductor substrate 802, and memory elements select devices 806 arranged within the semiconductor substrate 802. The select devices 806 are bipolar transistors which respectively include an emitter area 808, a base area 810, and a collector area 812. The emitter area 808 of each memory element select device 806 is connected to the resistance changing memory element 804 arranged above the memory element select device 806 via a conductive connection 818. The collector area 812 of the select device 806 is connected to a fixed potential via a conductive connection 820. The base area 810 of each select device 806 is connected to a word line 814 formed within a word line trench 816 reaching from the top surface of the semiconductor substrate 802 into the base area 810.

The word lines 814 can be manufactured very easy, compared to word lines located within the semiconductors substrate 802, e.g. below the memory element select devices 806 ("buried" word lines): The word lines 814 can be manufactured by simply forming the trenches 816 within the memory element select devices 806, followed by a process of filling conductive material into the trenches 816. This process is easier than forming buried word lines within the semiconductor substrate 802. Further, the use of trenches 816 enables to form word lines 814 having very small dimensions. As a consequence, the integration depth of the integrated circuit 800 can be chosen very high. Further, using a trench enables to use metal as a bit line material which has a lower electrical resistance than e.g. semiconductor material used in the case of semiconductor buried wordlines, for example.

According to one embodiment of the present invention, the word lines 814 are formed of metal.

The integrated circuit 800 shows the case where the collector area 812, the base area 810, and the emitter area 808 are stacked above each other in this order. However, the present invention is not restricted thereto: The positions of the collector area 812 and the emitter area 808 may also be exchanged with each other, i.e. the emitter area 808, the base area 810, and the collector area 812 may be stacked above each other in this order.

According to one embodiment of the present invention, the collector areas 812 may also be condensed into a single common collector area shared by all select devices 806. For example, the semiconductor substrate 802 itself (or at least a part thereof, e.g. a semiconductor well ("deep well") implanted into the semiconductor substrate 802) may serve as a common collector area. In this case, individual conductive connections 820 may be omitted. This reduces the number of contacts and reduces the dimensions of the integrated circuit.

Figure 9 shows an integrated circuit 900 according to one embodiment of the present invention. The integrated circuit 900 includes an isolation structure 902 which divides the semiconductor substrate 802 into a plurality of active areas 904 which are at least partly laterally isolated against each other. The isolation structure 902 is a trench structure filled with isolation material. It should be menitioned that also other kinds of isolation structures may be used. One effect of using a trench structure as isolation structure 902 is that an isolations structure 902 having very small lateral dimensions can be manufactured. As a consequence, the integration depth of the integrated circuit 900 can be increased.

At least a part of the inner walls of the word line trench 818 are covered by an isolation layer 906 which laterally isolates the word line 814 against (parts of) the active area 904. That is, the isolation layer 906 isolates the word line 814 against the emitter area 808 and a part of the base area 810.

The select devices 806 do not have individual collector areas. Instead, a plurality of select devices 806 share a common collector area 812' which may be the semiconductor substrate 802 itself or a common area (e.g. a semiconductor well) formed within the semiconductor substrate 802. Here, it is assumed that the a common collector area 812' is a well formed within the semiconductor substrate 802.

Each base area 810 includes a highly doped semiconductor area 908 of the same conductive type as the base area 810 being arranged below the word line trench 816 in order to improve the contact performance between the word line 814 and the base area 810.

Each resistance changing memory element 804 of the integrated circuit 900 is connected to a bit line 910 via a conductive connection 912.

The common collector area 812' is contacted by a highly doped semiconductor contacting area 914 having the same conductive type as the common collector area 812'. Also metal contacting areas may be used.

Here, the isolation structure 902 is both used to isolate the word lines 814 laterally against the semiconductor substrate 802 and to laterally isolate the active area 904 against its environment. Thus, the lateral dimensions of the resistance changing memory cells can be further reduced since one isolation area is used for two purposes.

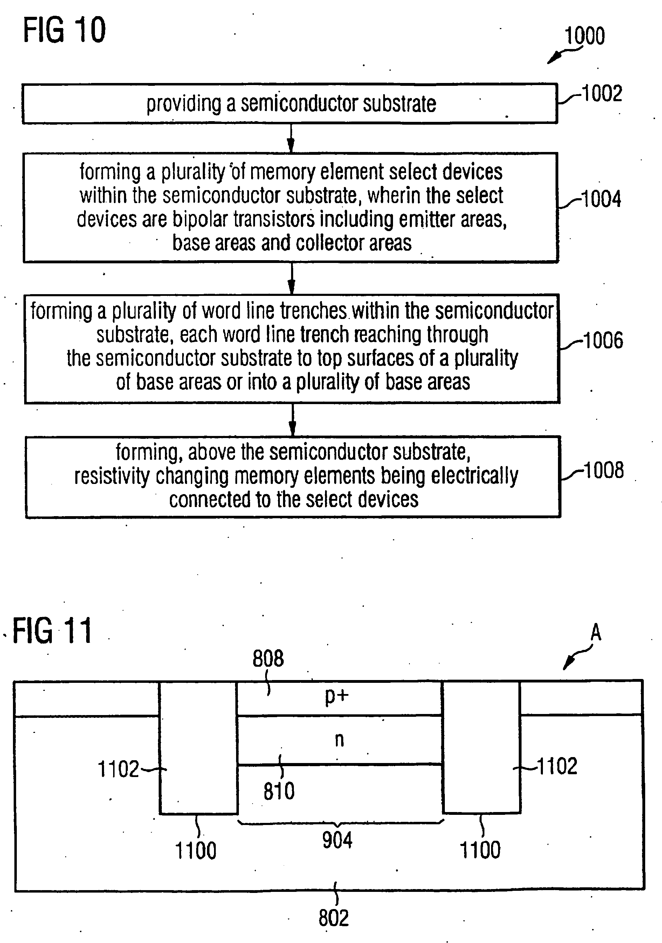

Figure 10 shows a method 1000 of manufacturing an integrated circuit . At 1002, a semiconductor substrate is provided. At 1004, a plurality of memory element select devices are formed within the semiconductor substrate wherein the select devices are bipolar transistors including emitter areas, base areas and collector areas. At 1006, the plurality of word line trenches are formed within the semiconductor substrate, each word line trench reaching through the semiconductor substrate to the top surface of a plurality of base areas or into a plurality of base areas, e.g. reaching from the top surface of the semiconductor substrate into the base areas. At 1008, resistance changing memory elements are formed above the semiconductor substrate, the memory elements being electrically connected to the select devices.

In the following description, making reference to figure 11 to 14, a method of manufacturing an integrated circuit according to one embodiment of the present invention will be explained.

Figure 11 shows a manufacturing stage A obtained after having formed isolation trenches 1100 within a p-doped semiconductor substrate 802 dividing the semiconductor substrate 802 into active areas 904. The isolation trenches 1100 have been filled with isolation material 1102. Further, in n-doped area (base area) 810 and a p⁺-doped area (emitter area) 808 have been formed within each active area 904 using for example implantation processes. The formation of the p⁺-doped area 808 within the active area 904 may for example be carried out by forming a p⁺-doped layer on or within the semiconductor substrate 802, followed by the formation of the isolation trenches 1100 extending through the p⁺-doped layer. The n-doped area (base area) 810 is for example formed by an implantation process, followed by an annealing process.

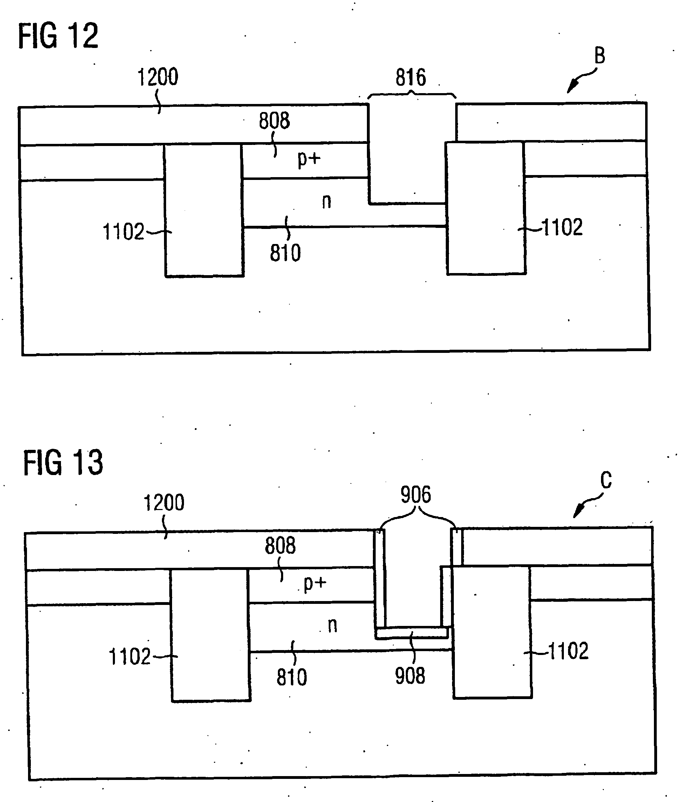

Figure 12 shows a manufacturing stage B obtained after having formed an isolation layer 1200 on the structure shown in Figure 11. The isolation layer 1200 may for example be an oxide layer. Furhter, the isolation layer 1200 has been patterned, and the patterned isolation layer 1200 has been used in order to form a word line trench 816 within the semiconductor substrate 802. The word line trench 816 is formed such that it reaches into the base area 810. The word line trench 816 is formed at or close to one of the isolation trenches 1100. In order not to damage the isolation material 1102 when forming the word line trench 816, the substance used for forming the world line trench 816 (e.g. etching substance) should be chosen such it does not damage the isolation material 902, e.g. the materials of the base area 810, the emitter area 808 and the isolation layer 1200 could be chosen to be selectively etchable over the isolation material 1102.

Figure 13 shows a manufacturing stage C obtained after having formed sidewallspacer 906 within the word line trench 816. The sidewallspacers 906 may be for example be oxide spacers. Further, doping material has been introduced into the word line trench 816 (before or after having formed the side wall spacers 906), thereby forming an n⁺-doped contact area 908 within the base area 810 (below the wordline trench).

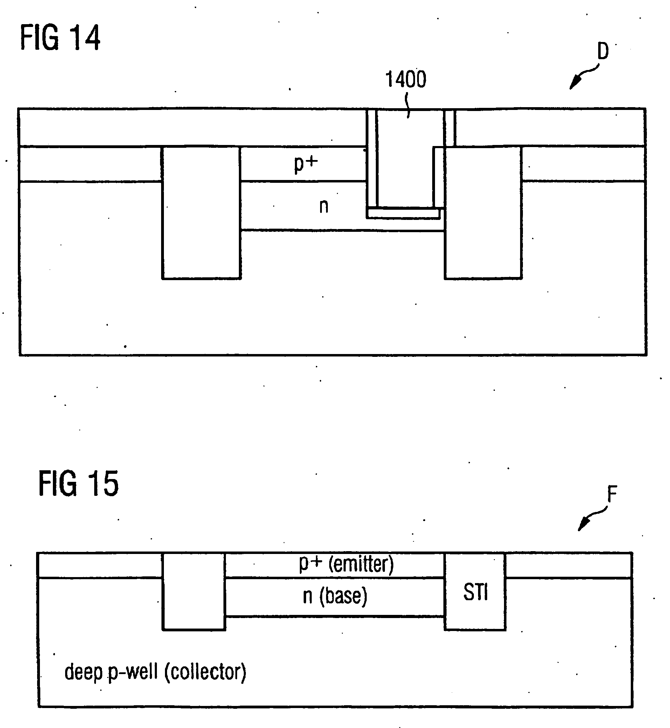

Figure 14 shows a manufacturing stage D obtained after having filled the word line trench 816 with conductive material 1400, for example titanium nitride or tungsten material.

After this, the conductive connection 818, the resistance changing memory element 804 (here: phase change memory element), the conductive connection 912, and the bit line 910 are formed, thereby obtaining the integrated circuit shown in figure 9.

In the following description, making reference to figures 15 to 17, a method of manufacturing an integrated circuit according to a further embodiment of the present invention will be explained.

Figure 15 shows a manufacturing stage F which is identical to the manufacturing stage A shown in figure 11.

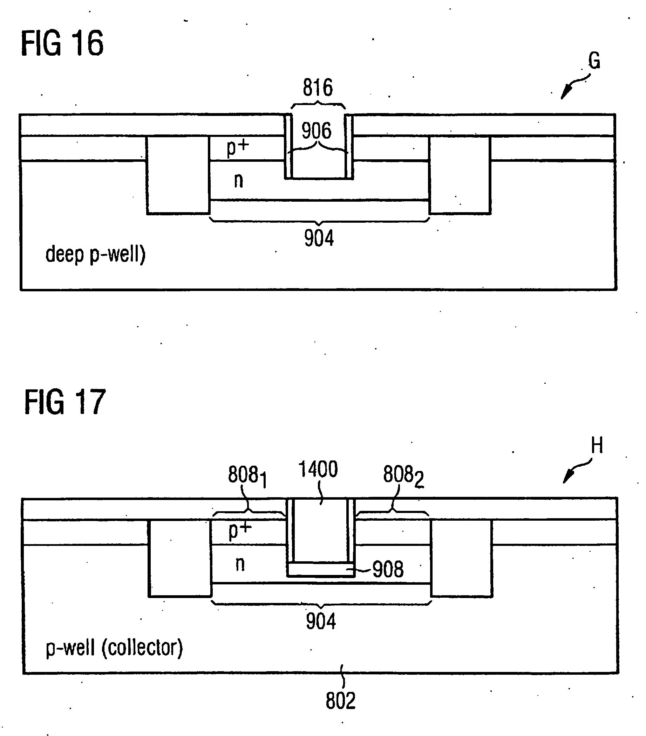

Figure 16 shows a manufacturing stage G which is similar to the manufacturing stage C shown in figure 13. However, figure 16 shows the case where the word line trench 816 has been formed within the center of the active area 904, whereas in figure 13, the word line trench 816 has been formed at the border of the active area 904.

Figure 17 shows a manufacturing stage H obtained after having formed a highly doped area 908 within the base area 810 having the same conductive type as the base area 810 by introducing doping material into the word line trench 816. Further, the word line trench 816 has been filled with conductive material 1400.

Then (not shown), conductive connections 818, resistance changing memory elements 804, conductive connections 912 as well as bit lines 910 are formed, wherein each active area 904 is contacted by two separate conductive connections 818 (i.e. each active area 904 is connected to two different resistance changing memory elements 804). One of the conductive connections 818 contacts a first emitter area 808₁, the other conductive connection 818 contacts a second emitter area 808_{2.} i.e, the word line trench 816 is located between the first emitter area 808₁ and the second emitter area 808₂. That is, two select devices are formed within one active area 904. The two select devices share a common word line 814.

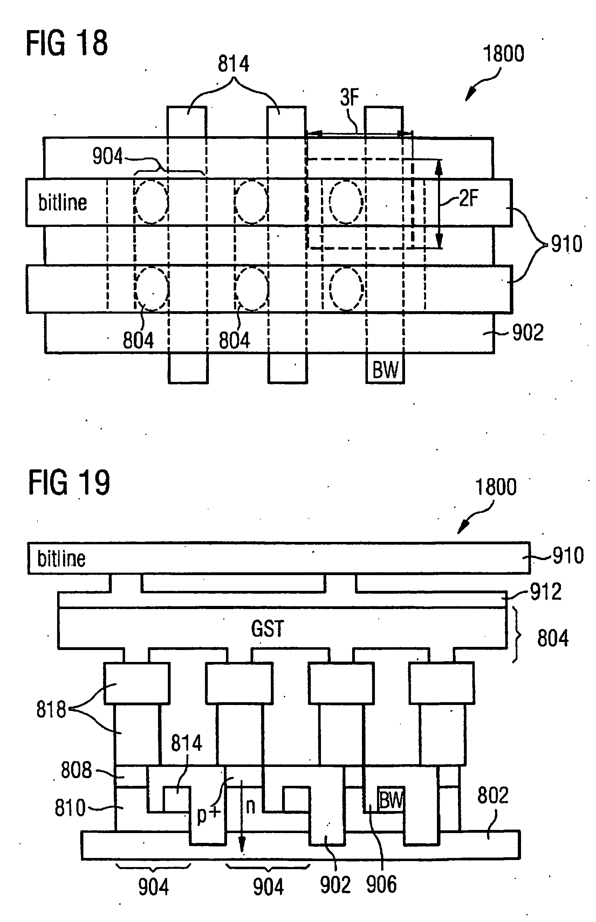

Figure 18 shows a top view of an integrated circuit 1800 being similar to the integrated circuit 900 shown in figure 9. Figure 19 shows a cross-sectional view of the integrated circuit 1800. In contrast to the integrated circuit 900, the integrated circuit 1800 includes word lines 814, the top surface of which being located below the uppermost top surfaces of the semiconductor substrate 802. That is, the height of the top surfaces of the word lines 814 coincides with the height of the uppermost parts of the top surfaces of the semiconductor base areas 810. In contrast, in figure 9, the height of the top surfaces of the word lines 814 coincides with the height of the top surfaces of the emitter areas 808. A further difference between the integrated circuit 900 and the integrated circuit 1800 is that, in the integrated circuit 1800, the resistance changing memory elements 804 together form a common, continuous resistance changing memory layer, whereas in the integrated circuit 900, the the resistance changing memory elements 804 are separated from each other.

Here, it is assumed that the resistance changing material layer is a phase change material. However, it is to be understood that the phase change material may also be replaced by other types of resistance changing material.

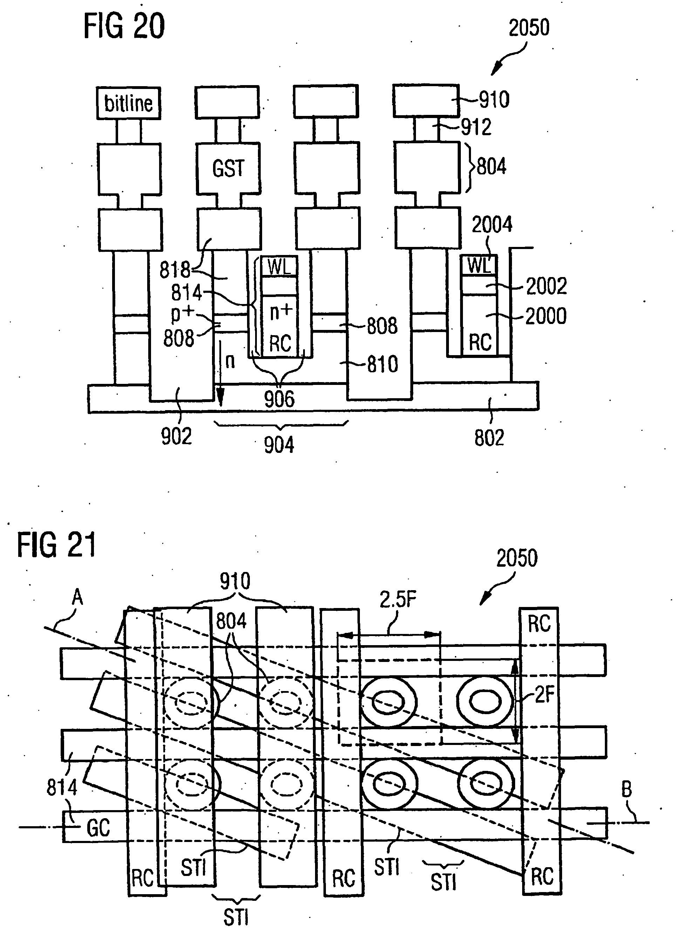

Figures 20 to 22 show a possible realisation of an Integrated circuit 2050 manufactured according to figures 15 to 17. Here, it is assumed that the word line 814 includes a semiconducting part 2000, a metal part 2002, and a word line cap part 2004 (isolation material), in contrast to the integrated circuit shown in figure 17 where the word line trench 816 has been filled only with conductive material 1400, for example only with metal. Like in the integrated circuit shown in figure 17, the integrated circuit 2050 includes word lines 814, the top surface of which being located above the uppermost top surfaces of the semiconductor substrate 802. That is, the height of the top surfaces of the word lines 814 is above the height of the uppermost parts of the top surfaces of the semiconductor emitter areas 808.

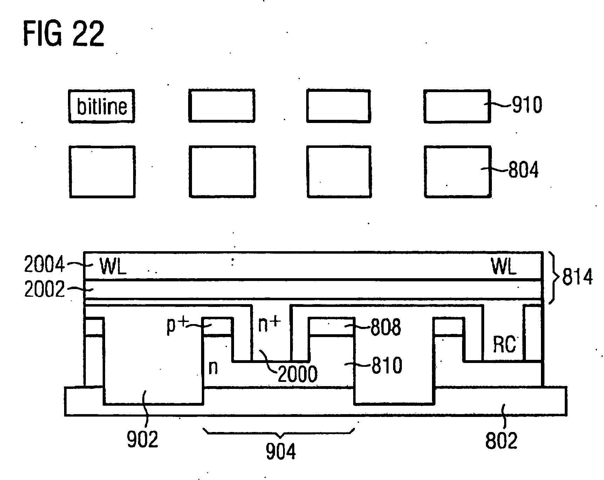

Figure 21 shows a top view of the integrated circuit 2050, wherein figure 20 represents a cut along line A indicated in figure 21, and wherein figure 22 represents a cut along line B indicated in figure 21.

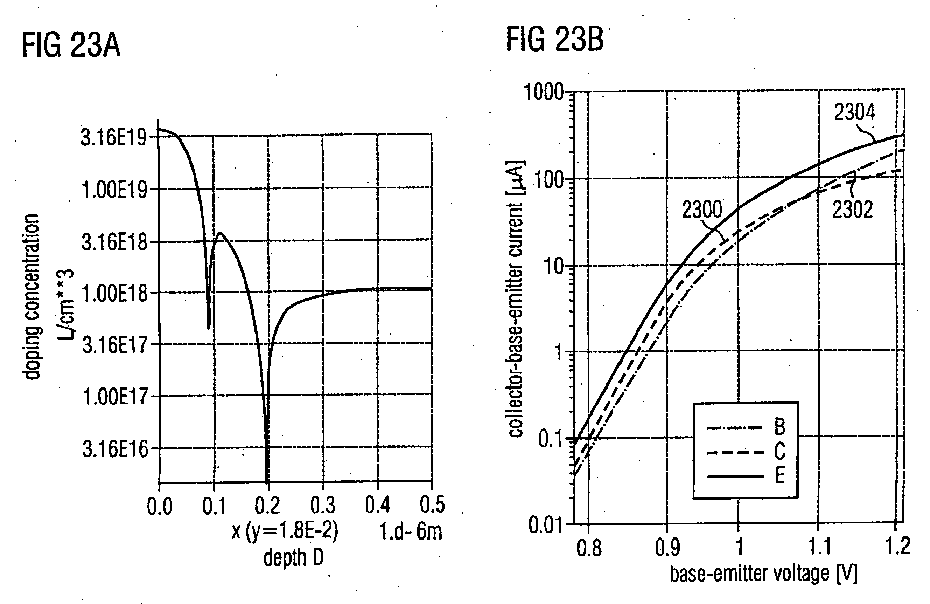

Figure 23A shows a possible doping profile of the select devices 806, wherein the x-axis represents the depth D reaching from the top surface of the emitter area 808 (i.e. from the top surface of the substrate 802) into the substrate 802, as for example indicated in figure 8. That is, figure 23A shows a vertical cut through the doping profile of a bipolar transistor. In the embodiment shown in figure 23A, the base area starts and ends at depths indicated by the minima, i.e. starts at a depth of about 0.09µm and ends at a depth of about 0.19µm. Figure 23B shows resulting (simulated) emitter-base-collector currents in dependence on base-emitter voltages for the doping scenario shown in figure 23A. As can be derived from figure 23B, the distance between the different curves corresponds to a gain factor of about 1. That is, curve 2300 shows the emitter current, curve 2302 shows the collector current, and curve 2304 shows the base current. The gain corresponds to the ratio of emitter current 2300 to base current 2304 and is approximately reflected by the ratio (doping emitter/doping base).

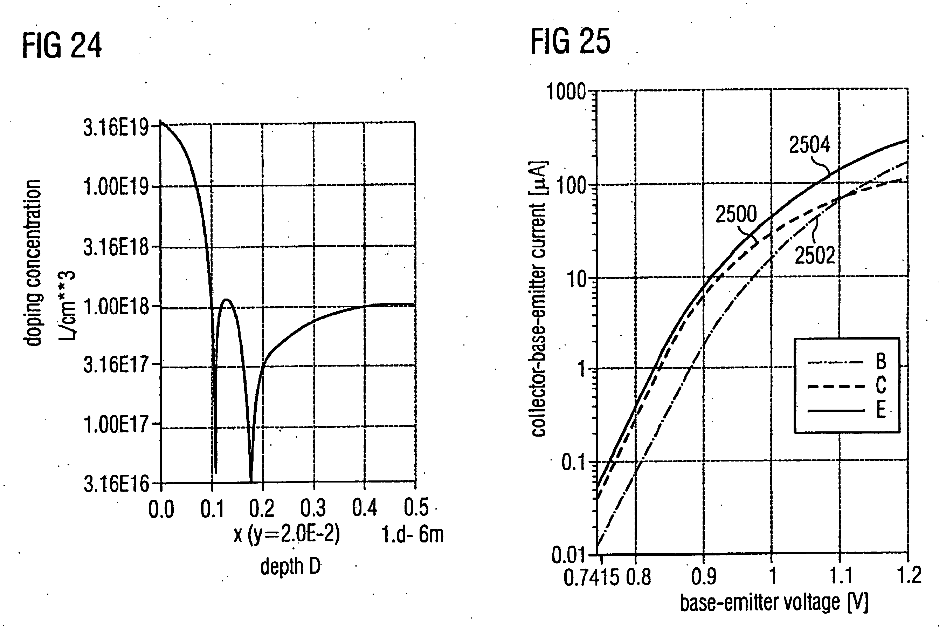

Figure 24 shows a possible doping profile of the select devices 806, wherein the x-axis represents the depth D reaching from the top surface of the emitter area 808 (i.e. from the top surface of the substrate 802) into the substrate 802, as for example indicated in figure 8. That is, figure 24 shows a vertical cut through the doping profile of a bipolar transistor. In the embodiment shown in figure 24, the base area starts and ends at depths indicated by the minima, i.e. starts at a depth of about 0.1 µm and ends at a depth of about 0.18µm. Figure 25 shows resulting (simulated) emitter-base-collector currents in dependence on base-emitter voltages for the doping scenario shown in figure 24. As can be derived from figure 25, the distance between the different curves corresponds to a gain factor of about 3 to 4. That is, curve 2500 shows the emitter current, curve 2502 shows the collector current, and curve 2504 shows the base current. The gain factor corresponds to the ratio of emitter current 2500 to base current 2504.

In the simulations shown in figures 23B and 25, it was assumed that the collector area is a boron (p) collector having a doping concentration of 4.5E13cm-2, and the base area 810 is a As (n) base having a concentration of 1 E14cm-2 (figure 23B) and of 6E13cm-2 (figure 25). The doping profile shown in figure 24 results in a gain of 3 to 4 which is better than the gain resulting from the doping profile shown in figure 23A, however which is more difficult to manufacture. Generally, a gain factor larger than 1 is desireable in order to reduce the base current and resistive voltage drops and to have the benefits of a bipolar transistor.

The manufacturing of the integrated circuit 1800 is very similar to the manufacturing of the integrated circuit 900 as shown in manufacturing processes A to D (figures 11 to 14). Thus, in the following, only a brief summary of an embodiment of manufacturing the integrated circuit 1800 will be given.

After having carried out typical front end of line (FEOL) processes, shallow trench isolations (STI) are formed in a semiconductor substrate, and wells are formed between the shallow trench isolations within the substrate, e.g. using an implantation process. The trenches include first trenches being arranged parallel with respect to each other, and include second trenches being arranged parallel with respect to each other, wherein the first trenches are arranged with respect to the second trenches by an angle being 90°. The wells form emitter areas, base areas and optionally collector areas and are formed within substrate areas surrounded by the first trenches and the second trenches. Then, buried word line grooves are etched within the substrate (e.g. silicon substrate) and the shallow trench isolations. Then, oxide spacers are formed within the word line grooves in order to cover the word line groove side walls. After this, an implantation process is carried out in order to form highly doped areas (e.g. n+ doped areas) within the semiconductor substrate below the word line grooves. Then, a thin liner like a titanium (Ti) or titanium nitride (TiN) liner is deposited into the word line grooves, wherein at least a part of the remaining space within the word line grooves is filled with metal, e.g. tungsten (W). After this, the metal is covered with an insulating cap layer like an oxide layer. After this, the doping concentration of the emitter areas may be increased. Alternatively, the emitter areas may be formed at this stage if they have not been formed before during the well formation processes. Then, an adaption layer like a CoSi layer may be formed on each emitter area in order to improve the contact properties between the emitter areas and conductive plugs formed on the emitter areas later on. Then, an inter layer dielectricum layer is deposited, and contact holes are formed within the inter dielectricum layer which are then filled with conductive material like tungsten (W) in order to form the conductive plugs. After this, a resistance changing memory layer is formed on the plugs which is connected by the plugs to the emitter areas. Further back end of line (BEOL) processes may be carried out in order to finalize the integrated circuit.

The manufacturing of the integrated circuit 2050 is very similar to the manufacturing of the integrated circuit as shown in manufacturing processes F to H (figures 15 to 17). Thus, in the following, only a brief summary of an embodiment of manufacturing the integrated circuit 2050 will be given.

After having carried out typical front end of line (FEOL) processes, shallow trench isolations (STI) are formed in a semiconductor substrate. The trenches include first trenches being arranged parallel with respect to each other, and include second trenches being arranged parallel with respect to each other, wherein the first trenches are inclined with respect to the second trenches by an angle being different from 90°. Wells are formed within substrate areas which are surrounded by the first trenches and the second trenches using for example an implantation process. The wells form emitter areas, base areas and optionally collector areas. Then, buried word line grooves are etched within the substrate areas (but not within the shallow trench isolations). After this, oxide spacers are formed within the word line grooves in order to cover the word line groove side walls. After this, an implantation process is carried out in order to form highly doped areas (e.g. n+ doped areas) within the semiconductor substrate below the word line grooves. Then, at least a part of the word line grooves is filled with higly doped semiconducting material, e.g, n+ doped poly, or is filled with metal like tungsten (W). After this, a planarization process is carried out. Then, further conductive layers like metal layers may be deposited and structured into word lines. The word lines may then be covered with isolation material (insulating cap layer) like an oxide layer. After this, the doping concentration of the emitter areas may be increased. Alternatively, the emitter areas may be formed at this stage if they have not been formed before during the well formation processes. Then, an adaption layer like a CoSi layer may be formed on each emitter area in order to improve the contact properties between the emitter areas and conductive plugs formed on the emitter areas later on. Then, an inter layer dielectricum (ILD) layer is deposited, and contact holes are formed within the inter layer dielectricum layer which are then filled with conductive material like tungsten (W) in order to form the conductive plugs. After this, a resistance changing memory elements are formed on the plugs. Further back end of line (BEOL) processes may be carried out in order to finalize the integrated circuit.

In the following description, further exemplary embodiments of the present invention will be explained.

An integrated circuit having resistance changing memory elements like a PCRAM circuit needs access devices which can provide high currents during write and erase operations. For example, in the 58nm PCRAM generation, reset currents for the amorphous state in the range of up to 300 µA will be needed to change the structure of the GST material at temperatures of about 400-600C. Using MOSFETs for the access device, similar as in DRAM, requires a large channel width in order to achieve a high current. On the other hand, this results in a large cell size, which is not compatible with a low cost memory. Therefore, there is a need for highly integrated PCRAM circuits with small size demand for access devices which neverthelesss can deliver high currents. Such access devices are for example bipolar transistors or diodes.

According to one embodiment of the present invention, low cost bipolar transistors with current gain 1-10 are used as access devices, thereby reducing the wordline current and resistance. The recessed trench is used for the base contact and a deep p-well for the collector may be added by implantation. The deep p-well may be implemented as a common ground plate collector, set e.g. to 0 Volt. The ground plate may be contacted in larger arrays with many contacts surrounding the p-well. Using a bipolar transistor has the advantage, that the current gain decreases the necessary base current and hence allows longer wordlines. Thus, resistance and voltage drops at the n+ buried wordline which are critical and which occur in diode arrays can be avoided. Using typical DRAM implantations for the emitter, base and collector adds no process complexity. Examples of possible doping profiles are given in Fig. 23A and 24. The current gain has been simulated on the basis of these doping profile using a 2D device simulator. Emitter/base current gains up to 10 and 3 will be expected using this device structure (doping profiles) for low and high base currents. Therefore, the base current is remarkably smaller than in the pure diode approach. Moreover, using the recess type base contact, the cell size is the same as that for the diode, except the additional contact chain for the deep p-well at the periphery of the memory array. Another effect is the lower resistance of the metal base line compared to n+ buried diffusion.

According to one embodiment of the present invention, a recess type metal base contact is used for contacting the base of a bipolar transistor and to use a deep p-well as a common collector. One effect is a low collector resistance, a small cell size, a lower base resistance and a lower base current. The bipolar transistor can be added easily to existing process flows.

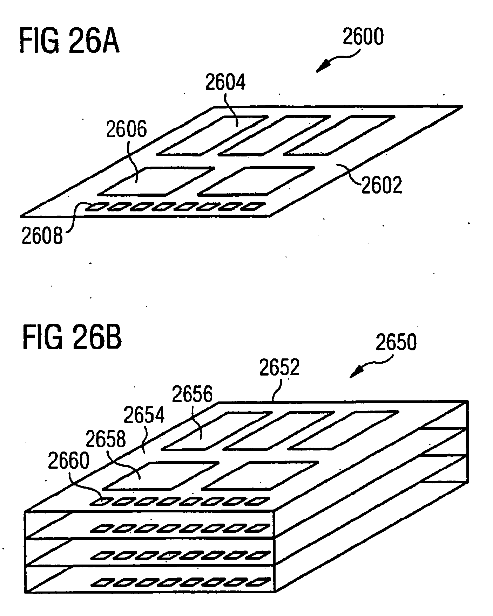

As shown in FIGS. 26A and 26B, in some embodiments, integrated circuits such as those described herein may be used in modules. In FIG. 26A, a memory module 2600 is shown, on which one or more integrated circuits 2604 are arranged on a substrate 2602. The integrated circuit 2604 may include numerous memory cells in accordance with an embodiment of the invention. The memory module 2600 may also include one or more electronic devices 2606, which may include memory, processing circuitry, control circuitry, addressing circuitry, bus interconnection circuitry, or other circuitry or electronic devices that may be combined on a module with a memory device, such as the integrated circuit 2604. Additionally, the memory module 2600 includes multiple electrical connections 2608, which may be used to connect the memory module 2600 to other electronic components, including other modules.

As shown in FIG. 26B, in some embodiments, these modules may be stackable, to form a stack 2650. For example, a stackable memory module 2652 may contain one or more integrated circuits 2656, arranged on a stackable substrate 2654. The integrated circuits 2656 contain memory cells in accordance with an embodiment of the invention. The stackable memory module 2652 may also include one or more electronic devices 2658, which may include memory, processing circuitry, control circuitry, addressing circuitry, bus interconnection circuitry, or other circuitry or electronic devices that may be combined on a module with a memory device, such as the integrated circuits 2656. Electrical connections 2660 are used to connect the stackable memory module 2652 with other modules in the stack 2650, or with other electronic devices. Other modules in the stack 2650 may include additional stackable memory modules, similar to the stackable memory module 2652 described above, or other types of stackable modules, such as stackable processing modules, control modules, communication modules, or other modules containing electronic components.

## Claims

1. An integrated circuit, comprising:
resistance changing memory elements (804) arranged above a semiconductor substrate (802),
memory element select devices (806) each arranged within an active area (904) formed within the semiconductor substrate (802), the select devices each being a bipolar transistor comprising an emitter area (808), a base area (810) and a collector area (812, 812'),
wherein the base area (810) of each select device is connected to a word line (814) formed within a word line trench (816) reaching through the semiconductor substrate (802) to a top surface of the base area or into the base area,
wherein each memory element is connected to one of the select devices (806) and wherein at least a part of the inner walls of the word line trench is covered with an isolation layer (906), which laterally isolates the word line (814) against the active area (904),
wherein the base area (810) includes a highly doped semiconductor area (908) which is arranged below the word line trench (816).

2. The integrated circuit according to claim 1,
wherein the word line (814) comprises metal.

3. The integrated circuit according to one of the claim 1-2,
wherein the base areas (810) are arranged above the collector areas (812, 812'), and the emitter areas (808) are arranged above the base areas (810), and
wherein the collector areas (812, 812') form a common collector area shared by all select devices (806).

4. The integrated circuit according to one of the claims 1-3, further comprising:
an isolation structure (902, 1102) which divides the semiconductor substrate (802) into a plurality of active areas (904) which are at least partly laterally isolated against each other, wherein the isolation structure (902, 1100) is a trench structure (1100) filled with isolation material:

5. The integrated circuit according to one of the claims 1-4, further comprising:
a plurality of conductive connections (818), each conductive connection (818) connecting an emitter area (808) of an active area (904) to one of the memory elements (806) assigned to the active area (904).

6. The integrated circuit according to one of the claims 1-5,
wherein, within each active area (904), one select device (806) and one word line trench (816) are provided, wherein the emitter area (808) of the select device (806) is connected to one of the memory elements (804) assigned to the select device (806) by a conductive connection (818) being arranged adjacent to the word line trench (816).

7. The integrated circuit according to one of the claims 1-6,
wherein, within each active area (904), two select devices (806) and one word line trench (816) are provided, wherein the emitter area (808) of each select device (806) is connected to one of the memory elements (804) assigned to the select device (806) by a conductive connection (818), and
wherein the word line trench (816) is arranged between the conductive connections (818).

8. The integrated circuit according to one of the claims 1-7,
wherein the gain factor of each bipolar transistor ranges between 1 and 10.

9. A method of manufacturing an integrated circuit, comprising:
forming a plurality of memory element select devices (806) within corresponding active areas formed within a semiconductor substrate (802), wherein the select devices (806) in each case are a bipolar transistor comprising an emitter area (808), a base area (810) and a collector area (812, 812'),
forming a plurality of word line trenches (816) within the semiconductor substrate (802), each word line trench (816) reaching from the top surface of the semiconductor substrate to top surfaces of a plurality of base areas or into a plurality of base areas (810),
filling the word line trenches (816) with conductive material,
forming, above the semiconductor substrate (802), resistance changing memory elements (804) being electrically connected to the select devices (806),
covering at least a part of the inner walls of the word line trenches (816) with an isolation layer (906) which in each case laterally isolates the conductive material against the corresponding active area (904), and
for each memory element (804), forming a highly doped semiconductor area (908) in the base area (810) below the word line trench (816).

10. The method according to claim 9, further comprising:
forming an isolation structure (902, 1102) within the semiconductor substrate (802) such that the semiconductor substrate (802) is divided into a plurality of active areas (904) which are at least partly laterally isolated against each other, wherein the isolation structure (902, 1102) is formed by forming a trench structure within the semiconductor substrate, and by filling the trench structure (1100) with isolation material.

11. The method according to one of the claims 9-10, further comprising:
forming a plurality of conductive connections (818), each conductive connection (818) connecting an emitter area (808) of an active area (904) to a memory element (806) assigned to the active area.

12. The method according to one of the claims 9-11,
wherein, within each active area (904), one select device (806) and one word line trench (816) are formed such that the emitter area (808) of the select device (806) is connected to one of the memory elements (804) assigned to the select device (806) by a conductive connection (818) being arranged adjacent to the word line trench (816).

13. The method according to one of the claims 9-12,
wherein, within each active area (904), two select devices (806) and one word line trench (816) are formed such that the emitter area (808) of each select device (806) is connected to one of the memory elements (804) assigned to the select device (806) by a conductive connection (818), and
wherein the word line trench (816) is arranged between the conductive connections (818).

## Patentansprüche

1. Integrierte Schaltung, umfassend:
widerstandsveränderliche Speicherelemente (804), die über einem Halbleitersubstrat (802) angeordnet sind,
Speicherelementauswahlvorrichtungen (806), die jeweils in einer im Halbleitersubstrat (802) ausgebildeten aktiven Zone (904) angeordnet sind, wobei es sich bei den Auswahlvorrichtungen jeweils um einen Bipolartransistor handelt, der eine Emitterzone (808), eine Basiszone (810) und eine Kollektorzone (812, 812') umfasst,
wobei die Basiszone (810) jeder Auswahlvorrichtung an eine Wortleitung (814) angeschlossen ist, die in einem Wortleitungsgraben (816) ausgebildet ist, der sich durch das Halbleitersubstrat (802) zu einer Oberseite der Basiszone oder in die Basiszone hinein erstreckt,
wobei jedes Speicherelement an eine der Auswahlvorrichtungen (806) angeschlossen ist, und
wobei zumindest ein Teil der Innenwände des Wortleitungsgrabens mit einer Isolierschicht (906) bedeckt ist, welche die Wortleitung (814) seitlich gegen die aktive Zone (904) isoliert,
wobei die Basiszone (810) eine hochdotierte Halbleiterzone (908) enthält, die unter dem Wortleitungsgraben (816) angeordnet ist.

2. Integrierte Schaltung nach Anspruch 1,
wobei die Wortleitung (814) Metall umfasst.

3. Integrierte Schaltung nach einem der Ansprüche 1 - 2,
wobei die Basiszonen (810) über den Kollektorzonen (812, 812') angeordnet sind, und die Emitterzonen (808) über den Basiszonen (810) angeordnet sind, und
wobei die Kollektorzonen (812, 812') eine gemeinsame Kollektorzone bilden, die von allen Auswahlvorrichtungen gemeinsam genutzt wird.

4. Integrierte Schaltung nach einem der Ansprüche 1 - 3, darüber hinaus umfassend:
eine Isolierstruktur (902, 1102), die das Halbleitersubstrat (802) in mehrere aktive Zonen (904) unterteilt, die zumindest teilweise seitlich gegeneinander isoliert sind, wobei es sich bei der Isolierstruktur (902, 1100) um eine mit Isoliermaterial gefüllte Grabenstruktur (1100) handelt.

5. Integrierte Schaltung nach einem der Ansprüche 1 - 4, darüber hinaus umfassend:
mehrere leitfähige Verbindungen (818), wobei jede leitfähige Verbindung (818) eine Emitterzone (808) einer aktiven Zone (904) mit einem der Speicherelemente (806) verbindet, das der aktiven Zone (904) zugeordnet ist.

6. Integrierte Schaltung nach einem der Ansprüche 1 - 5,
wobei in jeder aktiven Zone (904) eine Auswahlvorrichtung (806) und ein Wortleitungsgraben (816) vorgesehen sind, wobei die Emitterzone (808) der Auswahlvorrichtung (806) durch eine angrenzend an den Wortleitungsgraben (816) angeordnete leitfähige Verbindung (818) mit einem der Speicherelemente (804) verbunden ist, das der Auswahlvorrichtung (806) zugeordnet ist.

7. Integrierte Schaltung nach einem der Ansprüche 1 - 6,
wobei in jeder aktiven Zone (904) zwei Auswahlvorrichtungen (806) und ein Wortleitungsgraben (816) vorgesehen sind, wobei die Emitterzone (808) jeder Auswahlvorrichtung (806) durch eine leitfähige Verbindung (818) mit einem der Speicherelemente (804) verbunden ist, das der Auswahlvorrichtung (806) zugeordnet ist, und
wobei der Wortleitungsgraben (816) zwischen den leitfähigen Verbindungen (818) angeordnet ist.

8. Integrierte Schaltung nach einem der Ansprüche 1 - 7, wobei der Verstärkungsfaktor jedes Bipolartransistors zwischen 1 und 10 beträgt.

9. Verfahren zum Herstellen einer integrierten Schaltung, umfassend:
Ausbilden mehrerer Speicherelementauswahlvorrichtungen (06) in entsprechenden aktiven Zonen, die in einem Halbleitersubstrat (802) ausgebildet sind, wobei es sich bei den Auswahlvorrichtungen (806) jeweils um einen Bipolartransistor handelt, der eine Emitterzone (808), eine Basiszone (810) und eine Kollektorzone (812, 812') umfasst,
Ausbilden mehrerer Wortleitungsgräben (816) im Halbleitersubstrat (802), wobei sich jeder Wortleitungsgraben (816) von der Oberseite des Halbleitersubstrats zu Oberseiten mehrerer Basiszonen oder in mehrere Basiszonen (10) hinein erstreckt,
Füllen der Wortleitungsgräben (816) mit leitfähigem Material,
Ausbilden, über dem Halbleitersubstrat (802), von widerstandsveränderliche Speicherelementen (804), die elektrisch an die Auswahlvorrichtungen (806) angeschlossen sind,
Bedecken zumindest eines Teils der Innenwände der Wortleitungsgräben (16) mit einer Isolierschicht (906), die jeweils das leitfähige Material seitlich gegen die entsprechende aktive Zone (904) isoliert, und
für jedes Speicherelement (804), Ausbilden einer hochdotierten Halbleiterzone (908) in der Basiszone (810) unter dem Wortleitungsgraben (816).

10. Verfahren nach Anspruch 9, darüber hinaus umfassend:
Ausbilden einer Isolierstruktur (902,1102) im Halbleitersubstrat (802) so, dass das Halbleitersubstrat (802) in mehrere aktive Zonen (904) unterteilt ist, die zumindest teilweise seitlich gegeneinander isoliert sind, wobei die Isolierstruktur (902, 1102) durch Ausbilden einer Grabenstruktur im Halbleitersubstrat und durch Füllen der Grabenstruktur (1100) mit Isoliermaterial ausgebildet wird.

11. Verfahren nach einem der Ansprüche 9 - 10, darüber hinaus umfassend:
Ausbilden mehrerer leitfähiger Verbindungen (818), wobei jede leitfähige Verbindung (818) eine Emitterzone (808) einer aktiven Zone (904) mit einem Speicherelement (806) verbindet, das der aktiven Zone zugeordnet ist.

12. Verfahren nach einem der Ansprüche 9 - 11,
wobei in jeder aktiven Zone (904) eine Auswahlvorrichtung (806) und ein Wortleitungsgraben (816) so ausgebildet werden, dass die Emitterzone (808) der Auswahlvorrichtung (806) durch eine angrenzend an den Wortleitungsgraben (816) angeordnete leitfähige Verbindung (818) mit einem der Speicherelemente (804) verbunden ist, das der Auswahlvorrichtung (806) zugeordnet ist.

13. Verfahren nach einem der Ansprüche 9 - 12,
wobei in jeder aktiven Zone (904) zwei Auswahlvorrichtungen (806) und ein Wortleitungsgraben (816) so ausgebildet werden, dass die Emitterzone (808) jeder Auswahlvorrichtung (806) durch eine leitfähige Verbindung (818) mit einem der Speicherelemente (804) verbunden ist, das der Auswahlvorrichtung (806) zugeordnet ist, und wobei der Wortleitungsgraben (816) zwischen den leitfähigen Verbindungen (818) angeordnet ist.

## Revendications

1. Circuit intégré, comprenant:
des éléments de mémoire à changement de résistance (804) disposés au-dessus d'un substrat semi-conducteur (802),
des dispositifs de sélection d'élément de mémoire (806) disposés chacun au sein d'une zone active (904) formée au sein du substrat semi-conducteur (802), les dispositifs de sélection étant chacun un transistor bipolaire comprenant une zone d'émetteur (808), une zone de base (810) et une zone de collecteur (812, 812'),
où la zone de base (810) de chaque dispositif de sélection est connectée à une ligne de mots (814) formée au sein d'une tranchée de ligne de mots (816) s'avançant à travers le substrat semi-conducteur (802) vers une surface supérieure de la zone de base ou dans la zone de base,
où chaque élément de mémoire est connecté à un des dispositifs de sélection (806) et où au moins une partie des parois intérieures de la tranchée de ligne de mots est recouverte d'une couche d'isolation (906) qui isole latéralement la ligne de mots (814) par rapport à la zone active (904),
où la zone de base (810) inclut une zone semi-conductrice hautement dopée (908) qui est disposée sous la tranchée de ligne de mots (816).

2. Le circuit intégré selon la revendication 1,
où la ligne de mots (814) comprend du métal.

3. Le circuit intégré selon l'une des revendications 1 à 2,
où les zones de base (810) sont disposées au-dessus des zones de collecteur (812, 812'), et les zones d'émetteur (808) sont disposées au-dessus des zones de base (810), et où les zones de collecteur (812, 812') forment une zone de collecteur commune partagée par tous les dispositifs de sélection (806).

4. Le circuit intégré selon l'une des revendications 1 à 3, comprenant en outre:
une structure d'isolation (902, 1102) qui divise le substrat semi-conducteur (802) en une pluralité de zones actives (904) qui sont au moins en partie isolées latéralement l'une par rapport à l'autre, où la structure d'isolation (902, 1100) est une structure de tranchées (1100) remplie de matériau d'isolation.

5. Le circuit intégré selon l'une des revendications 1 à 4, comprenant en outre:
une pluralité de connexions conductrices (818), chaque connexion conductrice (818) connectant une zone d'émetteur (808) d'une zone active (904) à un des éléments de mémoire (806) assignés à la zone active (904).

6. Le circuit intégré selon l'une des revendications 1 à 5, où, au sein de chaque zone active (904), un dispositif de sélection (806) et une tranchée de ligne de mots (816) sont réalisés, où la zone d'émetteur (808) du dispositif de sélection (806) est connectée à un des éléments de mémoire (804) assignés au dispositif de sélection (806) par une connexion conductrice (818) disposée de façon adjacente à la tranchée de ligne de mots (816).

7. Le circuit intégré selon l'une des revendications 1 à 6, où, au sein de chaque zone active (904), deux dispositifs de sélection (806) et une tranchée de ligne de mots (816) sont réalisés, où la zone d'émetteur (808) de chaque dispositif de sélection (806) est connectée à un des éléments de mémoire (804) assignés au dispositif de sélection (806) par une connexion conductrice (818), et où la tranchée de ligne de mots (816) est disposée entre les connexions conductrices (818).

8. Le circuit intégré selon l'une des revendications 1 à 7, où le facteur de gain de chaque transistor bipolaire est compris entre 1 et 10.

9. Procédé de fabrication d'un circuit intégré, comprenant:
la formation d'une pluralité de dispositifs de sélection d'élément de mémoire (806) au sein de zones actives correspondantes formées au sein d'un substrat semi-conducteur (802), les dispositifs de sélection (806) étant dans chaque cas un transistor bipolaire comprenant une zone d'émetteur (808), une zone de base (810) et une zone de collecteur (812, 812'),
la formation d'une pluralité de tranchées de ligne de mots (816) au sein du substrat semi-conducteur (802), chaque tranchée de ligne de mots (816) allant de la surface supérieure du substrat semi-conducteur à des surfaces supérieures d'une pluralité de zones de base ou s'avançant dans une pluralité de zones de base (810),
le remplissage des tranchées de ligne de mots (816) avec du matériau conducteur,
la formation, au-dessus du substrat semi-conducteur (802), d'éléments de mémoire à changement de résistance (804) électriquement connectés aux dispositifs de sélection (806),
le recouvrement d'au moins une partie des parois intérieures des tranchées de ligne de mots (816) avec une couche d'isolation (906) qui dans chaque cas isole latéralement le matériau conducteur par rapport à la zone active correspondante (904), et
pour chaque élément de mémoire (804), la formation d'une zone semi-conductrice hautement dopée (908) dans la zone de base (810) sous la tranchée de ligne de mots (816).

10. Le procédé selon la revendication 9, comprenant en outre:
la formation d'une structure d'isolation (902, 1102) au sein du substrat semi-conducteur (802) de telle sorte que le substrat semi-conducteur (802) soit divisé en une pluralité de zones actives (904) qui sont au moins en partie isolées latéralement l'une par rapport à l'autre, où la structure d'isolation (902, 1102) est formée par formation d'une structure de tranchées au sein du substrat semi-conducteur, et par remplissage de la structure de tranchées (1100) avec du matériau d'isolation.

11. Le procédé selon l'une des revendications 9 à 10, comprenant en outre:
la formation d'une pluralité de connexions conductrices (818), chaque connexion conductrice (818) connectant une zone d'émetteur (808) d'une zone active (904) à un élément de mémoire (806) assigné à la zone active.

12. Le procédé selon l'une des revendications 9 à 11,
où, au sein de chaque zone active (904), un dispositif de sélection (806) et une tranchée de ligne de mots (816) sont formés de telle sorte que la zone d'émetteur (808) du dispositif de sélection (806) soit connectée à un des éléments de mémoire (804) assignés au dispositif de sélection (806) par une connexion conductrice (818) disposée de façon adjacente à la tranchée de ligne de mots (816).

13. Le procédé selon l'une des revendications 9 à 12,
où, au sein de chaque zone active (904), deux dispositifs de sélection (806) et une tranchée de ligne de mots (816) sont formés de telle sorte que la zone d'émetteur (808) de chaque dispositif de sélection (806) soit connectée à un des éléments de mémoire (804) assignés au dispositif de sélection (806) par une connexion conductrice (818), et où la tranchée de ligne de mots (816) est disposée entre les connexions conductrices (818).
